(19) Europäisches Patentamt
European Patent Office
Office européen des brevets

(11) **EP 2 483 675 B1**

(12) **EUROPÄISCHE PATENTSCHRIFT**

(45) Veröffentlichungstag und Bekanntmachung des Hinweises auf die Patenterteilung:
**29.05.2019 Patentblatt 2019/22**

(21) Anmeldenummer: **10743101.7**

(22) Anmeldetag: **10.08.2010**

(51) Int Cl.:
*G01N 29/02* (2006.01)  *G01N 29/036* (2006.01)
*G01N 27/00* (2006.01)  *H01L 41/083* (2006.01)
*H03H 9/17* (2006.01)

(86) Internationale Anmeldenummer:
**PCT/EP2010/061627**

(87) Internationale Veröffentlichungsnummer:
**WO 2011/038972 (07.04.2011 Gazette 2011/14)**

(54) **VORRICHTUNG UND VERFAHREN ZUM DETEKTIEREN MINDESTENS EINER SUBSTANZ**

DEVICE AND METHOD FOR DETECTING AT LEAST ONE SUBSTANCE

DISPOSITIF ET PROCÉDÉ PERMETTANT DE DÉTECTER AU MOINS UNE SUBSTANCE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **30.09.2009 DE 102009047807**

(43) Veröffentlichungstag der Anmeldung:
**08.08.2012 Patentblatt 2012/32**

(73) Patentinhaber: **Siemens Aktiengesellschaft 80333 München (DE)**

(72) Erfinder: **NIRSCHL, Martin 83278 Traunstein (DE)**

(56) Entgegenhaltungen:
DE-A1-102004 035 812  DE-A1-102005 061 344
DE-B4- 10 308 975  US-A1- 2006 232 361

• **DICKHERBER A ET AL: "Optimization and characterization of a ZnO biosensor array", SENSORS AND ACTUATORS A: PHYSICAL, ELSEVIER BV, NL, vol. 144, no. 1, 28 May 2008 (2008-05-28), pages 7-12, XP022620681, ISSN: 0924-4247, DOI: 10.1016/J.SNA.2008.01.007 [retrieved on 2008-01-19]**

EP 2 483 675 B1

**Beschreibung**

Die Erfindung betrifft eine Vorrichtung und ein Verfahren zum Detektieren mindestens einer Substanz

In der Chemie- oder Pharmaindustrie ist es wichtig, Analysen von Substanzen in einem Fluid mit einer geringen Probemenge und einem hohen Durchsatz durchzuführen.

Aus DE 10308975B4 ist ein piezoelektrischer Resonator bekannt, dessen Resonanzfrequenz sich ändert, wenn auf die Oberfläche des Resonators ein Fluid mit Substanzen aufgebracht wird, die von der Resonator-Oberfläche adsorbiert werden. Die Technologie, mit der der Resonator aufgebaut ist, wird auch "Film Bulk Accustic Wave Resonator" (FBAR) genannt. Die im Fluid vorhandene Substanz wird durch die chemisch sensitive Oberfläche des Resonators absorbiert. Durch Messen der Änderung der Resonanzfrequenz kann die Konzentration der Substanz im Fluid ermittelt werden. Meist ist es nur gewünscht, einen Parameter zu ermitteln, etwa die Masseanbindung der Substanz, wodurch auch die Konzentration der Substanz im Fluid geschlossen werden kann.

Die anderen Parameter, die die Resonanzfrequenz beeinflussen können, sind Störeinflüsse. Beispielsweise ändert sich die Resonatorfrequenz beispielsweise in Abhängigkeit von der Temperatur, mechanischem Stress oder Vibration. Diese ungewünschten Einflüsse müssen im Stand der Technik während der Messung konstant gehalten werden. Dies wird etwa mit einem Heizsystem erreicht, dass den Sensor/Akustischen Resonator auf einer konstanten Temperatur hält. Zudem wird der Messaufbau stabil gelagert, um Störungen durch Vibrationen zu vermeiden.

Eine Möglichkeit, Temperatur und Massenanbindung gleichzeitig auszulesen/ mithilfe des akustischen Resonators zu messen, ist, die Temperatur separat vom Resonator zu messen, etwa mit einem Platinwiderstand. Diese Methode ist wegen der Messungenauigkeit und Trägheit des Sensors ungenau.

DE 10 2004 035 812 A1 offenbart einen akustischen Resonator mit einem akustischen Spiegel, bei welchem der Grundmodus der akustischen Resonatorschwingung unterdrückbar ist.

DE 10 2005 061 344 A1 offenbart einen BAW-Resonator mit zwei akustischen Teilspiegeln mit voneinander abweichenden Schichtdicken.

Aufgabe der Erfindung ist es daher, eine Vorrichtung und ein Verfahren zur Detektion einer Substanz bereitzustellen, bei der mehrere Parameter der Vorrichtung ohne Hilfsmittel messbar sind.

Die Aufgabe der Erfindung wird gelöst durch die Merkmale der unabhängigen Patentansprüche.

Vorteilhafte Weiterbildungen der Erfindung sind in den abhängigen Patentansprüchen angegeben/dargestellt.

Unter Sorption ist die Ausbildung einer chemischen oder physikalischen Bindung der Substanz an den Oberflächenabschnitt zu verstehen. Die Sorption umfasst dabei sowohl eine Absorption als auch eine Adsorption. Bei der Absorption wird die Substanz beispielsweise durch eine Beschichtung des Resonators, die den Oberflächenabschnitt bildet, ohne Bildung einer Phasengrenze aufgenommen. Die Substanz wird in die Beschichtung inkorporiert. Bei der Adsorption kommt es dagegen zur Bildung einer Phasengrenze.

Insbesondere denkbar ist dabei eine Adsorption in Form einer Physisorption. Die Substanz lagert sich am Oberflächenabschnitt des Resonators durch Van der Waals- oder Dipol-Dipol-Wechselwirkungen an. Alternativ dazu kann auch eine Adsorption in Form einer Chemisorption stattfinden. Bei einer Chemisorption lagert sich die Substanz am Oberflächenabschnitt unter Bildung einer chemischen Bindung an. Die chemische Bindung ist beispielsweise eine kovalente Bindung oder eine Wasserstoffbrückenbindung.

Vorzugsweise findet die Sorption reversibel statt. Dies bedeutet, dass die Substanz vom Oberflächenabschnitt auch wieder desorbiert (entfernt) werden kann. Beispielsweise wird die Substanz durch Temperaturerhöhung des Oberflächenabschnitts oder durch Einwirken eines reaktiven Stoffes wieder entfernt. Der reaktive Stoff ist beispielsweise eine Säure oder eine Lauge, mit deren Hilfe die bei der Chemisorption gebildeten Bindungen gelöst werden. Die Vorrichtung kann auf diese Weise mehrmals benutzt werden. Möglich ist aber auch, dass die Sorption irreversibel ist. Die Vorrichtung wird als Einwegsensor nur einmalig verwendet.

Das im Folgenden erwähnte Fluid ist beispielsweise aus einer wässrigen Lösung oder als Lösungsmittel auf Kohlenwasserstoffbasis ausgebildet. Es kann aber auch ein Gas mit einem zu detektierenden Gasbestandteil sein. Als Substanz kommt jede denkbare chemische oder biologische Verbindung in Frage. So kann die Vorrichtung als Gassensor zur Detektion eines Gases eingesetzt werden. Das Gas ist eine Substanz, die einen bestimmten Dampfdruck aufweist. Derartige Substanzen sind beispielsweise organische Lösungsmittel. Denkbar ist auch, dass eine derartige Substanz ein Sprengstoff oder ein Bestandteil, ein Vorprodukt oder ein Abbauprodukt eines Sprengstoffs ist. Die Vorrichtung kann als Sprengstoffdetektor eingesetzt werden. Denkbar ist auch, dass die Vorrichtung als Biosensor zur Detektion eines beliebigen Biomoleküls ausgestaltet ist. Das Biomolekül ist beispielsweise eine DNA (Deoxyribonucleic Acid)-Sequenz oder ein makromolekulares Protein.

Der Oberflächenabschnitt ist vorzugsweise derart ausgebildet, dass selektiv eine bestimmte Substanz oder Substanzklasse nach dem Schlüssel-Schloss-Prinzip sorbiert und damit erkannt wird. Somit ist es möglich, aus einem Gemisch aus einer Vielzahl von Substanzen mit Hilfe der Vorrichtung selektiv eine bestimmte Substanz zu detektieren. Die Detektion umfasst dabei sowohl eine qualitative als auch quantitative Bestimmung der Substanz. Es kann die Abwesenheit oder die Anwesenheit der Substanz im Fluid nachgewiesen werden. Es kann auch die Konzentration der Substanz im Fluid bestimmt werden. Durch differentielle Detektion der Substanz kann auch eine zeitliche Änderung der Konzentration der Substanz bestimmt werden. Somit eignet sich die Vorrichtung beispielsweise auch zur Reaktionskontrolle einer chemischen Reaktion, an der die Substanz beteiligt ist.

Der Oberflächenabschnitt kann aber auch mit einem Material zur selektiven oder unselektiven Anbindung einer nachzuweisenden Substanz versehen sein, das nicht oder nicht nur chemisch sensitiv, sondern spezifisch selektiv oder unselektiv und/oder sorptionsfähig für eine nachzuweisende Substanz oder ein Reaktions- bzw. Mischprodukt sein kann. Alternativ kann das Material fähig sein zur Aufnahme von Ablagerungen oder Abscheidungen der vorher genannten Substanzen.

Insbesondere weist die chemisch sensitive Beschichtung Moleküle zum Erkennen der Substanz auf. Zum Erkennen einer bestimmten DNA-Sequenz sind derartige Moleküle entsprechende Oligonukleotide (Oligos) aus mehreren Nukleotiden.

Die Moleküle zum Erkennen der Substanz können dabei direkt mit einer Transducer-Oberfläche verbunden sein. Beispielsweise ist die Transducer-Oberfläche eine Gold-Elektrode des Resonators. Moleküle, die über eine Thiol-Gruppe verfügen, werden durch Ausbilden einer Gold-Schwefel-Bindung direkt an die Transducer-Oberfläche gebunden.

Bei einem akustischen Spiegel greift man auf die aus der Optik bekannte Technik der Bragg-Spiegel zurück, bei der Lichtwellen an gestapelten dünnen Schichten reflektiert werden, deren Dicke ungefähr einem Viertel der Lichtwellenlänge entsprechen. Dazu wird der eigentliche Resonator durch eine Sequenz aus weiteren aufeinander gestapelten Dünnschichten mit abwechselnd niedriger und hoher akustischer Impedanz unterstützt. Diese Schichten wirken als akustische Reflektoren, auch als akustischer Spiegel bezeichnet, und entkoppeln den Resonator akustisch vom Trägersubstrat. Die akustische Impedanz Z einer Schicht ist dabei definiert als Z= $\sigma$*v wobei $\sigma$ die Dichte der Schicht und v die Ausbreitungs- oder Schallgeschwindigkeit der akustischen Welle bezeichnen. Der Spiegel stellt somit eine Bandsperre dar, deren Sperrfrequenz so ausgebildet ist, dass sie mit der Resonanzfrequenz des Resonators übereinstimmt. Als Trägersubstrat des Resonators und des akustischen Spiegels dienen vorzugsweise Siliziumscheiben (engl. Wafer), die einen hohen Ohmschen Widerstand bzw. eine hohe Impedanz aufweisen.

Die erfindungsgemäße Vorrichtung zum Detektieren mindestens einer Substanz weist auf einen Träger, auf den ein Resonator aufgebracht ist, der auf seiner vom Träger abgewandten Oberfläche mit einer chemisch sensitiven Schicht zur selektiven Anbindung einer zu detektierenden Substanz versehen ist. Zwischen dem Träger und dem Resonator ist ein akustischer Spiegel zum Entkoppeln der akustischen Wellen des Resonators vom Träger angeordnet. Der akustische Spiegel ist als Bandsperre ausgebildet, die zwei benachbarte Sperrfrequenzen aufweist, bei denen die Wellen des Resonators zumindest teilweise reflektiert werden. Die Vorrichtung ist bei zwei messbaren Frequenzen in Resonanz, wodurch rechnerisch sowohl die Masseanbindung als auch Temperaturänderungen ermittelbar sind. Alternativ sind auch mehr als zwei Sperrfrequenzen mit daraus folgenden Resonanzfrequenzen möglich, wodurch mehr als zwei Parameter ermittelbar sind.

Die Resonanzfrequenz des Resonators bei fast hundertprozentiger Entkopplung vom Träger liegt zwischen den beiden Sperrfrequenzen des Spiegels, wodurch eine hohe Güte der Resonanz-Schwingkreise erzielt wird.

Bevorzugt ist der Resonator über den Spiegel an den Träger akustisch angekoppelt, so dass die Resonanzfrequenz der Vorrichtung sich von der Resonanzfrequenz des Resonators in Richtung der beiden Sperrfrequenzen des Spiegels auf eine erste und eine zweite Resonanzfrequenz der Vorrichtung verstimmt.

Der Resonator weist eine Dicke auf, die der Hälfte der Resonanzwellenlänge des Resonators bei fast hundertprozentiger Entkopplung vom Träger entspricht, wodurch Resonanzfrequenzen der Vorrichtung mit hoher Güte einfach bestimmbar sind.

Der akustische Spiegel weist ausgehend vom Resonator mehrfach aufeinanderfolgend eine Schicht mit höherer akustischer Impedanz und eine Schicht mit niedrigerer akustischer Resonanz auf, wobei die Schichtdicken der Schichten jeweils etwa einem Viertel der Wellenlänge der Resonanzfrequenz des Resonators entsprechen, wobei mindestens eine der Schichten mit der geringen akustischen Impedanz oder der höheren akustischen Impedanz eine Dicke zwischen einem Viertel und der Hälfte der Wellenlänge im Resonator aufweist. Dadurch sind bewährte Fertigungsprozesse einsetzbar.

Ausgehend vom Resonator stellt die Schicht mit der höheren Dicke die zweite, vierte oder sechste Schicht dar. Dadurch sind ebenfalls bewährte Fertigungsprozesse einsetzbar.

Der Resonator ist durch elektrische Energie anregbar und enthält ein piezoelektrisches Element als aktives Element und ist vorzugsweise als Film Bulk Acoustic Wave Resonator (FBAR) ausgebildet, wobei der Resonator mit elektrischen Anschlüssen zur Zuführung der elektrischen Energie versehen ist.

Eine Auswerteinheit ist zum elektrischen Ansteuern des Resonators und zum Messen der jeweils aktuellen Frequenz, insbesondere der Resonanzfrequenzen, vorhanden. Dadurch sind die Mess- und Rechenergebnisse quasi online verfügbar.

Die Differenz der beiden Resonanzfrequenzen der Vorrichtung liegt zwischen einem Siebtel und einem Zwanzigstel des arithmetischen Mittels der beiden Resonanzfrequenzen, wodurch die Resonanzfrequenzen mit hoher Präzision messbar sind.

Die Massesensitivität bei der ersten Resonanzfrequenz weicht von der Massesensitivität der zweiten Resonanzfrequenz ab. Die Temperatursensitivität bei der ersten Resonanzfrequenz weicht von der Temperatursensitivität der zweiten Resonanzfrequenz ab. Durch Messen der aktuellen Resonanzfrequenzen bzw. deren Verschiebungen gegenüber den ursprünglichen Resonanzfrequenzen zu Beginn der Messung bei einer vorgegebenen Referenztemperatur und einer vorgegebenen Referenzmasse ist die Massenanbindung $\Delta m$ und die Temperaturänderung $\Delta T$ rechnerisch ermittelbar. Die Messungen der Resonanzfrequenzen werden in einem jeweils möglichst geringen Zeitversatz hintereinander ausgeführt. Mit Hilfe der digitalen Messtechnik ist sogar ein quasi gleichzeitiges Erfassen der Resonanzfrequenzen möglich. Dadurch sind auch schnell eintretende Temperatur- oder Masseänderungen mit hoher Auflösung ermittelbar.

Die aktuelle Masseanbindung der nachzuweisenden Substanz an die chemisch sensitive Schicht und/oder die aktuelle Temperaturänderung ist mit Hilfe der folgenden Formeln ermittelbar:

$$\Delta m = \frac{\Delta fR1 * kT2 - \Delta fR2 * kT1}{km2 * kT1 - km1 * kT2} \qquad \text{(Gleichung 1)}$$

$$\Delta T = \frac{\Delta fR1 * km2 - \Delta fR2 * km1}{km2 * kT1 - km1 * kT2} \qquad \text{(Gleichung 2)}$$

mit

$\Delta$ fR1: Änderung der ersten Resonanzfrequenz der Vorrichtung gegenüber einem Vorwert oder Referenzwert,
$\Delta$ fR2: Änderung der zweiten Resonanzfrequenz der Vorrichtung gegenüber einem Vorwert oder Referenzwert,
km1: Massesensitivität der ersten Resonanzfrequenz der Vorrichtung
km2: Massesensitivität der zweiten Resonanzfrequenz der Vorrichtung
kT1: die Temperatursensitivität der ersten Resonanzfrequenz der Vorrichtung
kT2: die Temperatursensitivität der zweiten Resonanzfrequenz der Vorrichtung

Dabei ist die Massesensitivität wie folgt definiert:

$$km = \Delta f / \Delta m = cm * fR/m \cong (\text{=proportional zu}) \; fR^2 \qquad \text{(Gleichung 3)}$$

wobei km die Massensensitivität der Vorrichtung, fR die Resonanzfrequenz der Vorrichtung ohne adsorbierte Substanz, cm eine materialspezifische Konstante und m die Masse des Resonators pro Flächeneinheit ist, wobei die Massensensitivität km proportional zum Quadrat der Resonanzfrequenz fR der Vorrichtung ist.

Die Temperatursensitivität kT ist wie folgt definiert:

$$kT = \Delta f / \Delta T = cT * fR/T \qquad \text{(Gleichung 4)},$$

wobei kT die Temperatursensitivität der Vorrichtung, fR die Resonanzfrequenz der Vorrichtung bei einer vorgegebenen Referenztemperatur T_ref, cT eine materialspezifische Konstante und T die Temperatur des Resonators ist.

Die Temperatursensitivität ist u. a. abhängig von Materialeigenschaften der Vorrichtung.

Die beiden Resonanzfrequenzen werden abwechselnd oder gleichzeitig zur Erfassung der beiden aktuellen Resonanzfrequenzen ausgelesen.

Der Resonator ist durch ein elektrisches Wechselfeld anregbar und vorzugsweise als Film Bulk Acoustic Wave Resonator (FBAR) ausgebildet mit einem piezoelektrisches Element als aktivem Element des Resonators. Das Wechselfeld weist vorzugsweise mehrere Frequenzen im Bereich der Resonanzfrequenzen gleichzeitig auf, wodurch die wichtigsten Resonanzfrequenzen der Vorrichtung kontinuierlich angeregt sind. Dadurch kann die Auswerteinheit zum elektrischen Ansteuern des Resonators und zum Messen der Resonanzfrequenzen die Resonanzfrequenzen in schnellem Wechsel oder sogar (fast) gleichzeitig messen. Aus den beiden gemessenen Resonanzfrequenzen werden die Masseanbindung und die Temperatur ausgerechnet, wobei aus der Masseanbindung insbesondere die Konzentration einer Substanz aus einem Fluid messbar ist. Es ist ein fast verzögerungsfreies Erfassen der Temperatur und/oder Masseänderung der Vorrichtung möglich. Die Auswerteinheit ist entweder auf dem Träger oder extern vorhanden.

Die Temperatur der Vorrichtung wird geändert, dabei werden die beiden Resonanzfrequenzen fR1, fR2 der Vorrichtung kontinuierlich gemessen, woraus die aktuelle Temperatur T bzw. die Temperaturänderung ΔT und die aktuelle Masseanbindung Δm ermittelt wird, wodurch eine Vielzahl von biologischen und chemischen Vorgängen ermittelbar sind, beispielsweise das Ermitteln der Schmelztemperatur von DNS oder die Untersuchung der Wärmebeständigkeit von Substanzen, insbesondere von Proteinen, beispielsweise Hitzeschockproteinen (engl. Heat Shock Proteins).

Die Masseanbindung wird unter Herausrechnen der Schwankungen der Temperatur ermittelt, auch wenn die Umgebungstemperatur schwankt oder sich der Sensor bzw. die Vorrichtung selbst aufheizt.

Im Folgenden sind die Figuren zur Erläuterung der Erfindung dargestellt.

Es zeigen:

Figur 1     eine Vorrichtung zum Detektieren einer Substanz mit einem auf einem Träger aufgebrachten Resonator und einem dazwischen angeordneten akustischen Spiegel in einem schematischen Querschnitt.

Figur 2     eine weitere Ausführungsform der Vorrichtung aus Figur 1 mit einem verstimmten akustischen Spiegel

Figur 3     eine weitere Ausführungsform der Vorrichtung aus Figur 1 mit einem leicht verstimmten akustischen Spiegel

Figur 4a     ein Diagramm mit der Darstellung der Impedanz-Frequenzabhängigkeit der Vorrichtung aus Figur 1

Figur 4b     ein Diagramm mit der Darstellung der Impedanz-Frequenzabhängigkeit der Vorrichtung aus Figur 2

Figur 4c     ein Diagramm mit der Darstellung der Impedanz-Frequenzabhängigkeit der Vorrichtung aus Figur 3

Figur 4d     ein Diagramm mit Messergebnissen der Impedanz-Frequenzabhängigkeit einer weiteren Vorrichtung aus Figur 2

In den folgenden Figuren werden funktionsgleiche Elemente der Vorrichtung 20 mit den gleichen Bezugszeichen dargestellt.

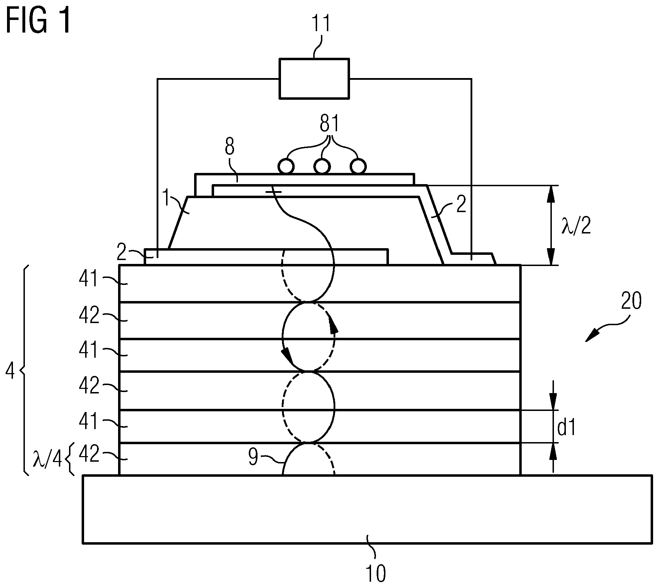

Die Figur 1 zeigt eine Vorrichtung 20 mit einem vorzugsweise piezoelektrisch ausgebildeten Resonator 1, der über an dessen Ober- und Unterseite angeordnete Elektroden 2 elektrisch zu Schwingungen anregbar ist. Die Dicke des Resonators 1 bzw. dessen piezoelektrischen Schicht ist umgekehrt proportional zur Resonanzfrequenz fR des Resonators 1 und beträgt die Hälfte der Resonanzwellenlänge λ, d.h. λ/2. Der Resonator 1 ist auf einen vorzugsweise als Siliziumscheibe (engl. Wafer) ausgebildeten Träger 10 aufgebracht, wobei zwischen dem Resonator 1 und dem Träger 10 ein akustischer Spiegel 4 angeordnet ist, der zur Entkopplung der vom Resonator 1 erzeugten akustischen Wellen λ gegenüber dem Träger 10 dient.

Auf dem Resonator 1 und oberhalb bzw. neben dem oberen elektrischen Leiter 2 ist eine chemisch-sensitive Schicht 8 zur Adsorption einer nachzuweisenden Substanz 81 aufgebracht. Die auf der Schicht 81 adsorbierte Masse erhöht die Gesamtmasse des Resonators 1, wodurch sich die Resonanzfrequenz fR der Vorrichtung verringert. Bei einer Resonanzfrequenz fR der Vorrichtung 20 im Bereich von 1 GHz wird eine hohe Massesensitivität km erzielt. Die Definition der Massesensitivität km wird in der Beschreibungseinleitung näher beschrieben.

Bei Aufbringen eines Fluids auf die Vorrichtung 20, sei es flüssig oder gasförmig mit darin enthaltenen nachzuweisenden Substanzen 81 bzw. Gasarten 81, ist es möglich, die Masse m der auf der Schicht 8 adsorbierten Substanz 81 durch Messen der Frequenzänderung deltafR der Resonanzfrequenz fR zu ermitteln. Somit stellt die Vorrichtung 20 einen kostengünstigen Sensor mit hoher Empfindlichkeit für nachzuweisende Substanzen 81 dar.

Der Oberflächenabschnitt der Schicht 8 kann aber auch mit einem Material versehen sein, das nicht oder nicht nur chemisch sensitiv, sondern spezifisch selektives oder unselektives Verhalten aufweist und/oder sorptionsfähig für eine nachzuweisende Substanz oder ein Reaktions- bzw. Mischprodukt sein kann. Alternativ kann das Material fähig sein zur Aufnahme von Ablagerungen oder Abscheidungen der vorher genannten Substanzen.

An die Vorrichtung 20 aus Figur 1 ist an die elektrischen Kontakte 2 des Resonators 1 eine Ansteuer- und Messeinheit 11 angeschlossen, die den Resonator 1 mit einer vorgegebenen Frequenz f zum Schwingen anregt und den Frequenzgang der Impedanz Z mit ihrer jeweiligen Amplitude bzw. ihrem Betrag | Z | und ihrer Phase Zpas misst.

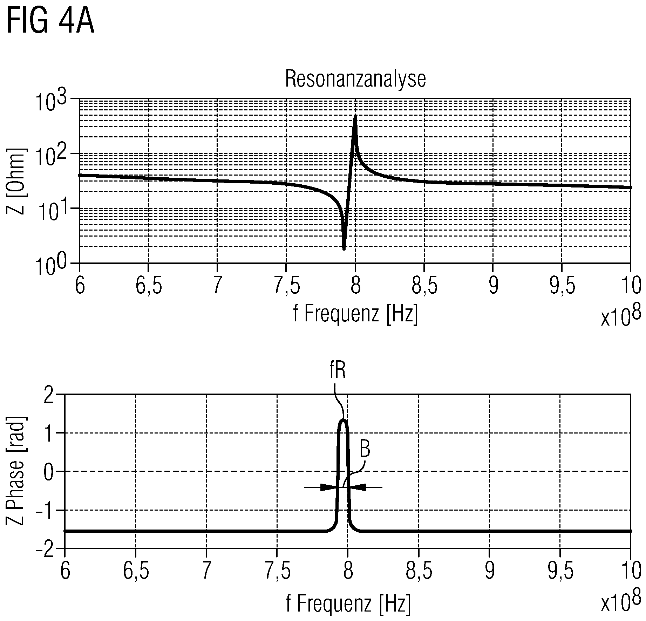

Mit Hilfe des akustischen Spiegels 4 verbessert sich die Güte des Resonators 1, da dessen Verluste gegenüber dem Substrat 10 verringert werden. Der akustische Spiegel 4 ist als Reflektorstapel mit drei Paar Spiegelschichten 41,42 ausgebildet, bei denen jedes angeordnete Paar 41, 42 ausgehend vom Resonator 1 vorzugsweise aus einer vorzugsweise aus Metall bestehenden Schicht 41 mit höherer akustischer Impedanz Z1 sowie einer nachfolgenden vorzugsweise dielektrisch ausgebildeten Schicht 42 mit niedriger akustischer Impedanz Z2 besteht. Die Höhe bzw. die Dicke des Materials 41 mit hoher akustischer Impedanz Z1 und die Dicke des Materials 42 mit niedriger akustischer Impedanz betragen jeweils ein Viertel (λ/4) der Resonanzwellenlänge λ des Resonators 1. Der akustische Spiegel 4 stellt eine Bandsperre mit einer Sperrfrequenz fRS dar, die gleich der Resonanzfrequenz fR des Resonators 1 gewählt ist. Dadurch werden die Wellen des Resonators 1 bei dessen Resonanzfrequenz fR am stärksten reflektiert, wodurch die Vorrichtung 20 mit hoher Güte schwingt, was anhand des Frequenzgangs der Impedanz Z in Figur 4a dargestellt ist.

Die Frequenzbereiche um und zwischen den Resonanzfrequenzen fR1 und fR2 werden von der Ansteuer- und Messeinheit 11 schnell hintereinander oder mit Hilfe eines Mehrfrequenzspektrums im Bereich der Resonanzfrequenzen fR1 und fR2 gleichzeitig angesteuert, so dass die aktuellen Resonanzfrequenzen fR1, fR2 wiederholt erfasst werden, bevorzugt mit einer möglichst hohen Wiederholfrequenz von mehreren Hz bis zu mehreren tausend Hz. Bei digitalen Messaufnehmern sind auch höhere Wiederholfrequenzen möglich. Die beiden Unbekannten "Massenanbindung Δm" und "Temperaturänderung ΔT" lassen sich dadurch mit Hilfe der obenstehenden Formeln extrahieren.

In Figur 4a ist die Impedanz Z mit dessen Betrag | Z | (Ohmscher Widerstand) und dessen Phase Zphas in Abhängigkeit von der Frequenz f der Vorrichtung 20 aus Figur 1 dargestellt. Hier liegt die Resonanzfrequenz fR der Vorrichtung 20 bei knapp unter 800 MHz, wobei die Bandbreite B mit etwa 20MHz klein ist im Verhältnis zur Resonanzfrequenz fR, was einer hohen Schwingungsgüte der Vorrichtung 20 entspricht. Der Phasengang mit der Phase ZPhas(f) stellt den üblichen Verlauf bei Auftreten einer Resonanz im Frequenzgang dar.

Weiterhin ist in Figur 1 der Wellenverlauf einer vom Resonator 1 erzeugten im Spiegel 4 verlaufenden Welle 9 dargestellt, die von der Deckfläche mit der Schicht 8 des Resonators 1 in einem Wellenberg ausgehend um λ/2 ebenfalls in einem Wellenberg an den akustischen Spiegel 4 grenzt. Die Welle 9 verläuft weiter in Richtung Träger 10 und passiert die jeweils λ/4-dicken Schichten 41,42,41,42,41,42, bis die Welle 9 geschwächt am Träger 10 angelangt ist. An jeder der Grenzflächen der Schichten 41,42 bzw. 42,41 wird ein Teil der Wellenenergie der Welle 9 in Richtung des Resonators 1 reflektiert.

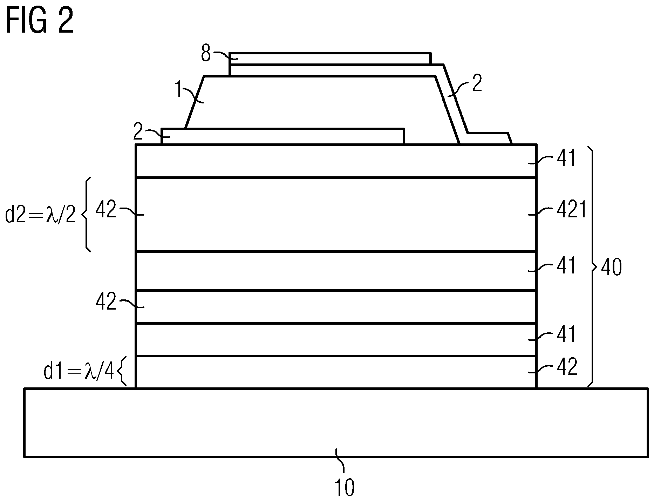

In Figur 2 ist eine Vorrichtung 20 aus Figur 1 dargestellt, bei der im Unterschied zur Figur 1 die ausgehend vom Resonator 1 erste niederohmige Schicht 42,421 mit niedrigerer Impedanz Z2 eine Schichtdicke von λ/2 aufweist. Die übrigen Schichten 41,42 behalten ihre Schichtdicken aus Figur 1 bei.

Dadurch wird die Bandsperre 4 aus Figur 1 so verstimmt, dass eine Bandsperre 40 mit zwei Sperrfrequenzen fRS1 und fRS2 entsteht. Oder auch anders ausgedrückt: Es entstehen zwei hintereinandergeschaltete Bandsperren mit jeweils einer ersten Sperrfrequenz fRS1 und einer zweiten Sperrfrequenz fRS2. Dabei sperrt der akustische Spiegel 40 nicht nur an einer Sperrfrequenz fRS wie in Figur 1, sondern an zwei mehr oder weniger dicht nebeneinander liegenden Sperrfrequenzen fRS1 und fRS2.

In den zwischen den beiden Sperrfrequenzen fRS1 und fRS2 liegenden und/oder außerhalb dieser liegenden Frequenzen f lässt der Spiegel 40 die akustischen Wellen 9 so stark zum Träger 10 durch, dass die Wellenenergieverluste so hoch werden, dass sich dort keine Resonanz des akustischen Resonators 1 einstellen kann. Die Resonanzfrequenz fR des Resonators 1 aus Figur 1 verschiebt sich in Figur 2 durch akustische Kopplung des Resonators 1 mit dem akustischen Spiegel 40 in Richtung der Sperrfrequenzen fRS1 und fRS2. Es ergeben sich zwei "neue" Resonanzfrequenzen fR1 und fR2 der Vorrichtung 20 aus Figur 2, wobei die Resonanzfrequenz fR1 des Resonators 1 vorzugsweise zwischen den Resonanzfrequenzen fR1 und fR2 liegt.

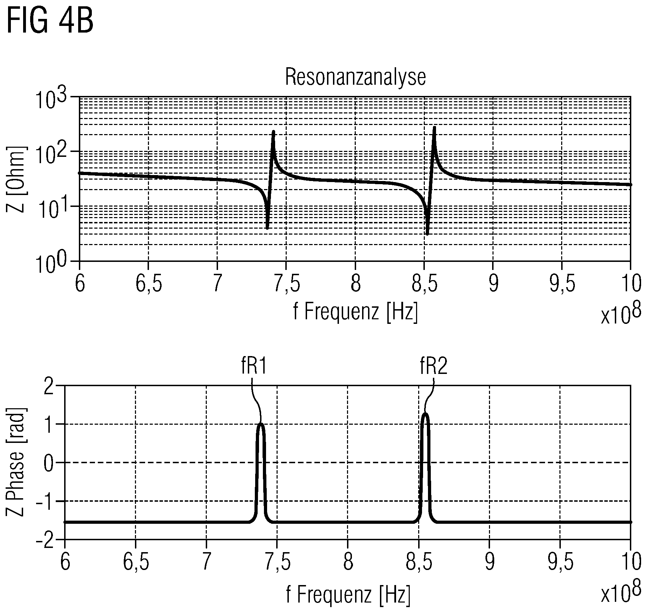

In Figur 4b ist die Impedanz Z mit dessen Betrag | Z | (Ohmscher Widerstand) und dessen Phase Zphas in Abhängigkeit von der Frequenz f der Vorrichtung 20 aus Figur 2 dargestellt. Hier liegen die Resonanzfrequenzen fR1 und fR2 bei etwa 740 MHz und 860 MHz, wobei die Resonanzfrequenz fR der Vorrichtung 20 aus Figur 1 mit etwa 800 MHz zwischen diesen liegt. Der Phasengang mit der Phase ZPhas(f) stellt den üblichen Verlauf bei Auftreten von Resonanzen im Frequenzgang dar.

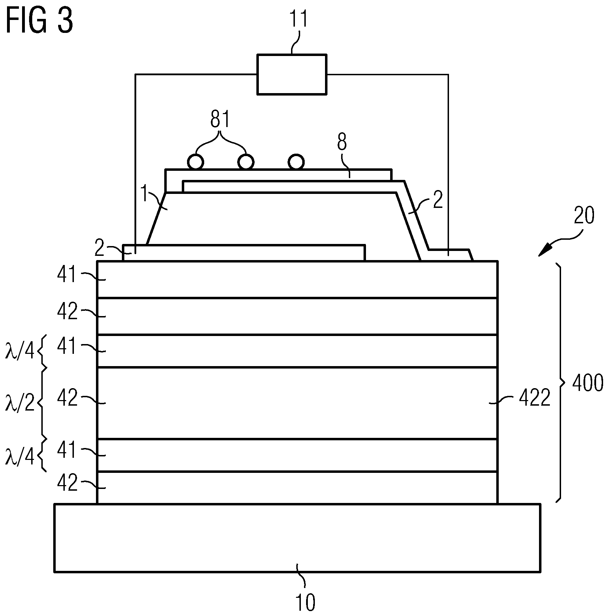

In Figur 3 ist eine Vorrichtung 20 aus Figur 1 dargestellt, bei der im Unterschied zur Figur 1 die ausgehend vom Resonator 1 zweite niederohmige Schicht 42,422 mit niedrigerer Impedanz Z2 eine Schichtdicke von λ/2 aufweist. Die übrigen Schichten 41,42 behalten ihre Schichtdicken aus Figur 1 bei.

Dadurch wird die Bandsperre 4 aus Figur 1 so verstimmt, dass eine Bandsperre 400 mit zwei Sperrfrequenzen fRS3 und fRS4 entsteht. Oder auch anders ausgedrückt: Es entstehen zwei hintereinandergeschaltete Bandsperren mit jeweils einer ersten Sperrfrequenz fRS3 und einer zweiten Sperrfrequenz fRS4. Dabei sperrt der akustische Spiegel 400 nicht nur an einer Sperrfrequenz fRS wie in Figur 1, sondern an zwei mehr oder weniger dicht nebeneinander liegenden Sperrfrequenzen fRS3 und fRS4, die dichter zusammenliegen als die Sperrfrequenzen fRS1 und fRS2 aus Figur 2. Die Schicht 422 mit der geringeren Impedanz (Z2) aus Figur 3 ist im Vergleich zur Schicht 421 aus Figur 2 weiter vom Resonator 1 entfernt, wodurch die zur "Verstimmung" der Bandsperre verfügbare Energie der Wellen bereits durch Reflexionen an mehreren darüberliegenden Schichten 41,42 stärker geschwächt ist. Dadurch wird die Bandsperre 400 aus Figur 3 weniger stark "verstimmt" als die Bandsperre 40 aus Figur 2, wodurch die Sperrfrequenzen fRS3 und fRS4 näher zusammenliegen.

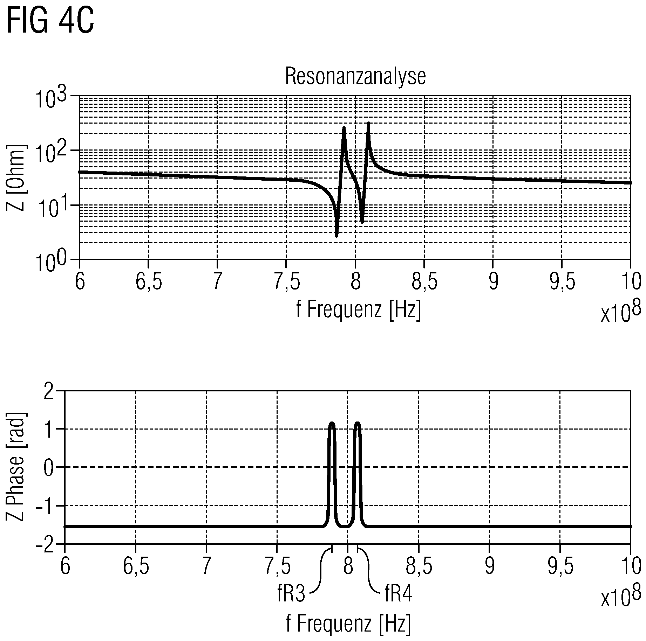

In Figur 4c ist die Impedanz Z mit dessen Betrag | Z | (Ohmscher Widerstand) und dessen Phase Zphas in Abhängigkeit von der Frequenz f der Vorrichtung 20 aus Figur 3 dargestellt. Hier liegen die Resonanzfrequenzen fR1 und fR2 bei etwa 780 MHz und 810 MHz, wobei die Resonanzfrequenz fR der Vorrichtung 20 aus Figur 1 mit knapp 800 MHz zwischen diesen liegt. Der Phasengang mit der Phase ZPhas(f) stellt den üblichen Verlauf bei Auftreten von Resonanzen im Frequenzgang dar.

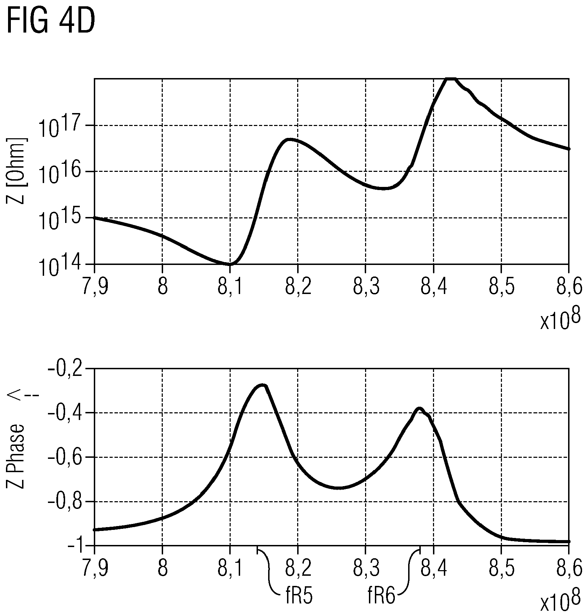

Figur 4d zeigt ein Diagramm mit Messungen einer zweiten Ausführung einer Vorrichtung 20 aus Figur 2, die eine etwas andere Bauform aufweist und aber ähnliche Ergebnisse wie aus Figur 4b bekannt erzeugt. Die Resonanzfrequenzen fR5 und fR6 liegen bei 814 MHz und 838 MHz.

Die aktuelle Masseanbindung Δm der nachzuweisenden Substanz 81 an die chemisch sensitive Schicht 8 und/oder die aktuelle Temperaturänderung (ΔT) ist aus den gemessenen Resonanzfrequenzen mit Hilfe der folgenden Formeln beispielhaft ermittelbar:

$$\Delta m = \frac{\Delta fR1 * kT2 - \Delta fR2 * kT1}{km2 * kT1 - km1 * kT2} \qquad \text{(Gleichung 1)}$$

$$\Delta T = \frac{\Delta fR1 * km2 - \Delta fR2 * km1}{km2 * kT1 - km1 * kT2|} \qquad \text{(Gleichung 2)}$$

mit

$\Delta$ fR1: Änderung der ersten Resonanzfrequenz fR1 der Vorrichtung 20 gegenüber einem Vorwert oder Referenzwert,
$\Delta$ fR2: Änderung der zweiten Resonanzfrequenz fR2 der Vorrichtung 20 gegenüber einem Vorwert oder Referenzwert,
km1: Massesensitivität bei der ersten Resonanzfrequenz fR1;fR3 der Vorrichtung 20
km2: Massesensitivität bei der zweiten Resonanzfrequenz fR2;fR4 der Vorrichtung 20
kT1: die Temperatursensitivität bei der ersten Resonanzfrequenz fR1;fR3 der Vorrichtung 20
kT2: die Temperatursensitivität bei der zweiten Resonanzfrequenz fR2;fR4 der Vorrichtung 20.

Mehrere λ/2-Schichten 41,42 hintereinander sind aus fertigungstechnischen Gründen besonders einfach herzustellen. Daher ist bevorzugt nur eine der Schichten 41,42 in ihrer Dicke verändert. In weiteren Ausführungsformen sind auch andere akustische Spiegel 4,40,400 denkbar, z.B. mit Schichtdicken zwischen λ/2 und λ/4. Weiterhin kann der akustische Spiegel 4,40,400 mehrere Schichten 41 mit höherer Impedanz Z1 mit Schichtdicken zwischen λ/4 und λ/2 aufweisen.

Das Material 41 mit höherer Impedanz Z1 ist bevorzugt aus Metall, bevorzugt aus Wolfram.

Das Material 42 mit geringerer Impedanz Z2 ist bevorzugt aus einem dielektrischen Material ausgebildet.

Alternativ ist es möglich, Vorrichtungen mit akustischen Spiegeln auszubilden, die drei oder mehrere eng zusammenliegende Resonanzfrequenzen aufweisen. Dadurch sind mehrere als zwei Unbekannte extrahierbar. Zum Beispiel Massenanbindung, Temperatur unter Einfluss von Vibrationen.

Dabei liegt bevorzugt der Abstand der Resonanzfrequenzen fR1, fR1 oder fR3, fR4 im Verhältnis zum arithmetischen Mittel der Resonanzfrequenzen fR1, fR1 bzw. fR3, fR4


**Patentansprüche**

1.    Vorrichtung zum Detektieren mindestens einer Substanz (81) aufweisend:

- einen Träger (10),
- einen auf den Träger (10) aufgebrachten Resonator (1), der auf seiner vom Träger (10) abgewandten Oberfläche mit einer Schicht (8) zur selektiven oder unselektiven Anbindung einer zu detektierenden Substanz (81) versehen ist, wobei zwischen dem Träger (10) und dem Resonator (1) ein akustischer Spiegel (4 41,42) zum Entkoppeln der akustischen Wellen des Resonators (1) vom Träger (10) angeordnet ist, wobei der akustische Spiegel (4) eine Bandsperre darstellt, die zwei benachbarte Sperrfrequenzen (fRS1,fRS2;fRS3,fRS4), d.h. zwei hintereinander geschaltete Bandsperren mit jeweils einer Sperrfrequenz (fRS1, fRS2; fRS3, fRS4), aufweist, bei denen die Wellen (9) des Resonators (1) zumindest teilweise reflektiert werden, wobei

die Resonanzfrequenz (fR) des Resonators (1) bei fast hundertprozentiger Entkopplung vom Träger (10) zwischen den beiden Sperrfrequenzen (fRS1, fRS2; fRS3, fRS4) des Spiegels (4) liegt.

2.    Vorrichtung nach Anspruch 1, bei welcher mehr als zwei Sperrfrequenzen (fRS1, fRS2; fRS3, fRS4) vorhanden sind.

3.    Vorrichtung nach Anspruch 1 oder 2, **dadurch gekennzeichnet, dass** der Resonator (1) über den Spiegel (4) an den Träger (10) akustisch angekoppelt ist, so dass die Resonanzfrequenz der Vorrichtung sich von der Resonanzfrequenz (fRS2, fRS2; fRS3, fRS4) des Resonators (1) in Richtung der beiden Sperrfrequenzen (fRS1,fRS2;fRS3,fRS4) des Spiegels (4) auf eine erste und eine zweite Resonanzfrequenz (fR1,fR2;fR3,fR4) der Vorrichtung (20) verstimmt.

4.    Vorrichtung nach einem der vorherigen Ansprüche, **dadurch gekennzeichnet, dass** der Resonator (1) eine Dicke (A/2) aufweist, die der Hälfte der Resonanzwellenlänge (λ, 1/fR) des Resonators (1) bei fast hundertprozentiger Entkopplung vom Träger (10 "idealer Resonator") entspricht.

5. Vorrichtung nach einem der vorherigen Ansprüche, **dadurch gekennzeichnet, dass** der akustische Spiegel (4) ausgehend vom Resonator (1) mehrfach aufeinanderfolgend eine Schicht (41) mit höherer akustischer Impedanz (Z1) und eine Schicht (42) mit niedrigerer akustischer Resonanz (Z2) aufweist, wobei die Schichtdicken (d1) der Schichten (41,42) jeweils etwa einem Viertel der Wellenlänge (λ/4) der Resonanzfrequenz (fR) des Resonators (1) entsprechen,
   wobei mindestens eine der Schichten (41,42) mit der geringen akustischen Impedanz (Z2) oder der höheren akustischen Impedanz (Z1) eine Dicke (d2) zwischen einem Viertel (λ/4) und der Hälfte (λ/2) der Wellenlänge im Resonator (1) aufweist.

6. Vorrichtung nach dem vorherigen Anspruch, **dadurch gekennzeichnet, dass** ausgehend vom Resonator (1) die Schicht (42) mit der höheren Dicke (d2) die zweite, vierte oder sechste Schicht (42) darstellt.

7. Vorrichtung nach einem der vorherigen Ansprüche, **dadurch gekennzeichnet, dass** der Resonator (1) durch elektrische Energie anregbar ist, ein piezoelektrisches Element als aktives Element enthält und vorzugsweise als Film Bulk Acoustic Wave Resonator (FBAR) ausgebildet ist, wobei der Resonator (1) mit elektrischen Anschlüssen (2) zur Zuführung der elektrischen Energie versehen ist.

8. Vorrichtung nach einem der vorherigen Ansprüche, **dadurch gekennzeichnet, dass** eine Auswerteinheit (11) zum elektrischen Ansteuern des Resonators (1) und zum Messen der jeweils aktuellen Frequenz (f), insbesondere der Resonanzfrequenzen (fR1,fR2;fR3,fR4) vorhanden ist.

9. Vorrichtung nach einem der vorherigen Ansprüche, **dadurch gekennzeichnet, dass** die Differenz der beiden Resonanzfrequenzen (fR1,fR2;fR3,fR4) der Vorrichtung (20) zwischen einem Siebtel und einem Zwanzigstel des arithmetischen Mittels der beiden Resonanzfrequenzen (fR1,fR2,;fR3,fR4) liegt.

10. Vorrichtung nach einem der vorherigen Ansprüche, **dadurch gekennzeichnet, dass** die Massesensitivität (km1) bei der ersten Resonanzfrequenz (fR1;fR3) von der Massesensitivität (km2) der zweiten Resonanzfrequenz (fR2;fR4) abweicht, und/oder die Temperatursensitivität (kT1) bei der ersten Resonanzfrequenz (fR1;fR3) von der Temperatursensitivität (kT2) der zweiten Resonanzfrequenz (fR2;fR4) abweicht, so dass durch Messen der aktuellen Resonanzfrequenzen (fRl,fR2;fR3,fR4) bzw. deren Verschiebungen (Δ fR1, Δ fR2) gegenüber vorgegebenen Referenz-Resonanzfrequenzen (fR1_ref, fR2_ref) bei einer vorgegebenen Referenztemperatur (T_ref) und einer vorgegebenen Referenzmasse (m_ref) die Massenanbindung (Δm) und die Temperaturänderung (ΔT) ermittelbar ist, wobei die Messungen der Resonanzfrequenzen (fR1, fR2; fR3, fR4) in einem jeweils vernachlässigbaren Zeitversatz hintereinander ausgeführt werden, vernachlässigbar ohne in diesem Zeitraum eintretende Temperaturänderung und/oder Masseänderung.

11. Vorrichtung nach Anspruch 9, **dadurch gekennzeichnet, dass** die aktuelle Masseanbindung (Δm) der nachzuweisenden Substanz (81) an die Schicht (8) und/oder die aktuelle Temperaturänderung (ΔT) mit Hilfe der folgenden Formeln ermittelbar ist:

$$\Delta m = \frac{\Delta fR1 * kT2 - \Delta fR2 * kT1}{km2 * kT1 - km1 * kT2} \qquad \text{(Gleichung 1)}$$

$$\Delta T = \frac{\Delta fR1 * km2 - \Delta fR2 * km1}{km2 * kT1 - km1 * kT2} \qquad \text{(Gleichung 2)}$$

mit

ΔfR1: Änderung der ersten Resonanzfrequenz (fR1)der Vorrichtung (20) gegenüber einem Vorwert oder Referenzwert,
ΔfR2: Änderung der zweiten Resonanzfrequenz (fR2)der Vorrichtung (20) gegenüber einem Vorwert () oder Referenzwert,
km1: Massesensitivität bei der ersten Resonanzfrequenz (fR1;fR3) der Vorrichtung (20)
km2: Massesensitivität bei der zweiten Resonanzfrequenz (fR2;fR4) der Vorrichtung (20)

kT1: die Temperatursensitivität bei der ersten Resonanzfrequenz (fR1;fR3) der Vorrichtung (20)

kT2: die Temperatursensitivität bei der zweiten Resonanzfrequenz (fR2;fR4) der Vorrichtung (20)

12. Vorrichtung nach Anspruch 10 oder 11, **dadurch gekennzeichnet, dass** die Massesensitivität km wie folgt definiert ist:

$$\mathrm{km} = \Delta f / \Delta m = cm * fR/m \cong fR^2 \qquad \text{(Gleichung 3)}$$

wobei km die Massensensitivität der Vorrichtung (20), fR die Resonanzfrequenz der Vorrichtung (20) ohne adsorbierte Substanz, cm eine materialspezifische Konstante und m die Masse des Resonators (1) pro Flächeneinheit ist, wobei die Massensensitivität km proportional zum Quadrat der Resonanzfrequenz fR der Vorrichtung (20) ist; die Temperatursensitivität kT wie folgt definiert ist:

$$\mathrm{kT} = \Delta f / \Delta T = cT * fR/T \qquad \text{(Gleichung 4)}$$

wobei kT die Temperatursensitivität der Vorrichtung (20), fR die Resonanzfrequenz der Vorrichtung (20) bei einer vorgegebenen Referenztemperatur (T_ref), cT eine materialspezifische Konstante und T die Temperatur des Resonators (1) bzw. der Vorrichtung (20) ist.

13. Verfahren zum Detektieren mindestens einer Substanz mit Hilfe einer Vorrichtung gemäß einem der vorherigen Vorrichtungsansprüche, **dadurch gekennzeichnet, dass** der Resonator (1) zur Erfassung zweier oder mehrerer aktueller Resonanzfrequenzen (fR1,fR2;fR3,fR4) im Bereich dieser mit einem Mehrfrequenzspektrum angesteuert wird.

14. Verfahren nach Verfahrensanspruch 13, **dadurch gekennzeichnet, dass** zur Messung der Masseanbindung/Masse der Substanz zeitnah beide naheliegenden Resonanzfrequenzen (fR1,fR2;fR2,fR4) gemessen werden, und aus den beiden gemessenen Resonanzfrequenzen die Masseanbindung und die Temperatur ausgerechnet werden, wobei aus der Masseanbindung insbesondere die Konzentration einer Substanz aus einem Fluid messbar ist.

15. Verfahren nach einem der vorherigen Verfahrensansprüche, **dadurch gekennzeichnet, dass** die Temperatur des Resonators/ des Sensors/der Vorrichtung geändert wird, die beiden Resonanzfrequenzen (fR1,fR2;fR3,fR4) der Vorrichtung (20) kontinuierlich gemessen werden, woraus die aktuelle Temperatur T bzw. die Temperaturänderung ΔT und die aktuelle Masseanbindung (Δm) ermittelt wird, wodurch eine Vielzahl von biologischen und chemischen Vorgängen ermittelbar sind, beispielsweise das Ermitteln der Schmelztemperatur von DNS oder die Untersuchung der Wärmebeständigkeit von Substanzen, insbesondere von Proteinen (Heat Shock Proteins).

16. Verfahren nach einem der vorherigen Verfahrensansprüche, **dadurch gekennzeichnet, dass** die Masseanbindung (Δm) unter Herausrechnen der Schwankungen (ΔT) der Temperatur ermittelt wird, auch wenn die Umgebungstemperatur schwankt oder sich der Sensor/die Vorrichtung (20) selbst aufheizt.

17. Verfahren nach einem der vorherigen Verfahrensansprüche, **dadurch gekennzeichnet, dass** zur Masseanbindung (Δm) anstatt oder zusätzlich zur Ermittlung der Temperaturänderung (ΔT) ein weitere Parameteränderung, z.B. mechanische Verformung oder Vibrationen, rechnerisch ermittelt wird.

## Claims

1. Device for detecting at least one substance (81), comprising:

   - a carrier (10),
   - a resonator (1) which is applied to the carrier (10) and which on its surface facing away from the carrier (10) is provided with a layer (8) for selectively or non-selectively binding a substance (81) requiring to be detected, wherein an acoustic mirror (4 41,42) for decoupling the acoustic waves of the resonator (1) from the carrier (10) is arranged between the carrier (10) and the resonator (1), wherein the acoustic mirror (4) constitutes a band elimination filter having two adjacent notch frequencies (fRS1,fRS2;fRS3,fRS4), i.e. two band elimination filters connected sequentially, each with a notch frequency (fRS1,fRS2;fRS3,fRS4), at which the waves (9) of the resonator (1) are at least partially reflected, wherein at almost one hundred percent decoupling from the carrier (10) the resonant frequency (fR) of the resonator (1) lies between the two notch frequencies (fRS1, fRS2; fRS3, fRS4) of the mirror (4).

2. Device according to claim 1, wherein more than two notch frequencies (fRS1, fRS2; fRS3, fRS4) are present.

3. Device according to claim 1 or 2, **characterised in that** the resonator (1) is acoustically coupled to the carrier (10) via the mirror (4) such that the resonant frequency of the device is detuned from the resonant frequency (fRS2, fRS2; fRS3, fRS4)) of the resonator (1) in the direction of the two notch frequencies (fRS1,fRS2;fRS3,fRS4) of the mirror (4) to a first and a second resonant frequency (fR1,fR2;fR3,fR4) of the device (20).

4. Device according to one of the preceding claims, **characterised in that** the resonator (1) has a thickness ($\lambda$/2) which is equivalent to half the resonance wavelength ($\lambda$, 1/fR) of the resonator (1) at almost one hundred percent decoupling from the carrier (10 "ideal resonator").

5. Device according to one of the preceding claims, **characterised in that** starting from the resonator (1) the acoustic mirror (4) has a layer (41) having higher acoustic impedance (Z1) and a layer having lower acoustic resonance (Z2) alternating with one another in multiple sequence, wherein the thicknesses (d1) of the layers (41,42) are in each case approximately equivalent to a quarter of the wavelength ($\lambda$/4) of the resonant frequency (fR) of the resonator (1), wherein at least one of the layers (41,42) having the low acoustic impedance (Z2) or the higher acoustic impedance (Z1) has a thickness (d2) between a quarter ($\lambda$/4) and half ($\lambda$/2) of the wavelength in the resonator (1).

6. Device according to the preceding claim, **characterised in that** starting from the resonator (1) the layer (42) having the greater thickness (d2) represents the second, fourth or sixth layer (42).

7. Device according to one of the preceding claims, **characterised in that** the resonator (1) can be excited by means of electrical energy, contains a piezoelectric element (1) as the active element (1) and is preferably embodied as a film bulk acoustic wave resonator (FBAR), the resonator (1) being provided with electrical terminals (2) to allow the electrical energy to be supplied.

8. Device according to one of the preceding claims, **characterised in that** an evaluation unit (11) is present for electrically driving the resonator (1) and for measuring the current frequency (f), in particular the resonant frequencies (fR1,fR2;fR3,fR4), at a given time.

9. Device according to one of the preceding claims, **characterised in that** the difference between the two resonant frequencies (fR1,fR2;fR3,fR4) of the device (20) lies between a seventh and a twentieth of the arithmetic mean of the two resonant frequencies (fR1,fR2,;fR3,fR4).

10. Device according to one of the preceding claims, **characterised in that** the mass sensitivity (km1) at the first resonant frequency (fR1;fR3) is different from the mass sensitivity (km2) of the second resonant frequency (fR2;fR4), and/or the temperature sensitivity (kT1) at the first resonant frequency (fR1;fR3) is different from the temperature sensitivity (kT2) of the second resonant frequency (fR2;fR4), such that the mass binding ($\Delta$m) and the change in temperature ($\Delta$T) can be determined by measuring the current resonant frequencies (fR1,fR2;fR3, fR4) or their shifts ($\Delta$fR1, $\Delta$fR2) with respect to predefined reference resonant frequencies (fR1_ref, fR2_ref) at a predefined reference temperature (T_ref) and a predefined reference mass (m_ref), wherein the measurements of the resonant frequencies (fR1, fR2; fR3, fR4) are taken sequentially with a negligible time offset in each case, negligible without a change in temperature and/or change in mass occurring in this time period.

11. Device according to claim 9, **characterised in that** the current mass binding ($\Delta$m) of the substance (81) to be detected to the layer (8) and/or the current change in temperature ($\Delta$T) can be determined with the aid of the following formulae:

$$\Delta m = \frac{\Delta fR1 * kT2 - \Delta fR2 * kT1}{km2 * kT1 - km1 * kT2} \qquad \text{(Equation 1)}$$

$$\Delta T = \frac{\Delta fR1 * km2 - \Delta fR2 * km1}{km2 * kT1 - km1 * kT2}$$       (Equation 2)

where

$\Delta$fR1: change in the first resonant frequency (fR1) of the device (20) with respect to a preliminary value or reference value,

$\Delta$fR2: change in the second resonant frequency (fR2) of the device (20) with respect to a preliminary value () or reference value,

km1: mass sensitivity at the first resonant frequency (fR1;fR3) of the device (20)

km2: mass sensitivity at the second resonant frequency (fR2;fR4) of the device (20)

kT1: the temperature sensitivity at the first resonant frequency (fR1;fR3) of the device (20)

kT2: the temperature sensitivity at the second resonant frequency (fR2;fR4) of the device (20).

**12.** Device according to claim 10 or 11, **characterised in that** the mass sensitivity km is defined as follows:

$$km = \Delta f / \Delta m = cm * fR/m \cong fR^2$$       (Equation 3)

where km is the mass sensitivity of the device (20), fR the resonant frequency of the device (20) without adsorbed substance, cm a material-specific constant, and m the mass of the resonator (1) per unit area, the mass sensitivity km being proportional to the square of the resonant frequency fR of the device (20);
the temperature sensitivity kT is defined as follows:

$$kT = \Delta f / \Delta T = cT * fR/T$$       (Equation 4)

where kT is the temperature sensitivity of the device (20), fR the resonant frequency of the device (20) at a predefined reference temperature (T_ref), cT a material-specific constant, and T the temperature of the resonator (1) or of the device (20)

**13.** Method for detecting at least one substance with the aid of a device as claimed in one of the preceding device claims, **characterised in that** the resonator (1) is driven by means of a multifrequency spectrum for the purpose of measuring two or more current resonant frequencies (fR1,fR2;fR3,fR4) in the region of the same.

**14.** Method according to method claim 13, **characterised in that** in order to measure the mass binding/mass of the substance the two closely adjacent resonant frequencies (fR1,fR2;fR2,fR4) are measured close to each other in time, and the mass binding and the temperature are computationally extracted from the two measured resonant frequencies, wherein in particular the concentration of a substance from a fluid can be measured from the mass binding.

**15.** Method according to one of the preceding method claims, **characterised in that**
the temperature of the resonator/of the sensor/of the device is changed, the two resonant frequencies (fR1,fR2;fR3,fR4) of the device (20) are measured continuously, from which
the current temperature T or the change in temperature $\Delta$T and the current mass binding ($\Delta$m) are determined, as a result of which a multiplicity of biological and chemical processes can be determined, for example the determination of the melting temperature of DNA, the investigation of the thermal resistance of substances, in particular proteins (heat shock proteins).

**16.** Method according to one of the preceding method claims, **characterised in that** the mass binding ($\Delta$m) is determined with computational extraction of the fluctuations ($\Delta$T) in the temperature, even if the ambient temperature varies or the sensor/device (20) itself heats up.

**17.** Method according to one of the preceding method claims, **characterised in that** in respect of the mass binding ($\Delta$m), instead of or in addition to determining the change in temperature ($\Delta$T), a further parameter change, e.g. mechanical deformation or vibrations, is determined computationally.

**Revendications**

1. Dispositif pour la détection d'au moins une substance (81) comprenant :

   - un support (10),
   - un résonateur (1) appliqué sur le support (10), lequel est pourvu sur sa surface opposée au support (10) d'une couche (8) pour la liaison sélective ou non sélective d'une substance à détecter (81), dans lequel est disposé, entre le support (10) et le résonateur (1), un miroir acoustique (4 41, 42) pour le découplage des ondes acoustiques du résonateur (1) du support (10), dans lequel le miroir acoustique (4) constitue un filtre coupe-bande qui présente deux fréquences de coupure voisines (fRS1, fRS2 ; fRS3, fRS4), c'est-à-dire deux filtres coupe-bande raccordés l'un derrière l'autre avec respectivement une fréquence de coupure (fRS1, fRS2 ; fRS3, fRS4), dans lesquels les ondes (9) du résonateur (1) sont réfléchies au moins en partie, dans lequel

   la fréquence de résonance (fR) du résonateur (1) lors du découplage à presque cent pour cent du support (10) est comprise entre les deux fréquences de coupure (fRS1, fRS2 ; fRS3, fRS4) du miroir (4).

2. Dispositif selon la revendication 1, dans lequel plus de deux fréquences de coupure (fRS1, fRS2 ; fRS3, fRS4) sont présentes.

3. Dispositif selon la revendication 1 ou la revendication 2, **caractérisé en ce que** le résonateur (1) est couplé acoustiquement au support (10) par l'intermédiaire du miroir (4) de sorte que la fréquence de résonance du dispositif se désaccorde de la fréquence de résonance (fRS2, fRS2 ; fRS3, fRS4) du résonateur (1) dans la direction des deux fréquences de coupure (fRS1, fRS2 ; fRS3, fRS4) du miroir (4) à une première et une deuxième fréquence de résonance (fR1, fR2 ; fR3, fR4) du dispositif (20).

4. Dispositif selon l'une des revendications précédentes, **caractérisé en ce que** le résonateur (1) présente une épaisseur ($\lambda$/2) qui correspond à la moitié de la longueur d'onde de résonance ($\lambda$, 1/fR) du résonateur (1) lors du découplage à presque cent pour cent du support (10 « résonateur idéal »).

5. Dispositif selon l'une des revendications précédentes, **caractérisé en ce que** le miroir acoustique (4) à partir du résonateur (1) comprend à plusieurs reprises successives une couche (41) avec une impédance acoustique supérieure (Z1) et une couche (42) avec une résonance acoustique inférieure (Z2), dans lequel les épaisseurs de couche (d1) des couches (41, 42) correspondent respectivement à environ un quart de la longueur d'onde ($\lambda$/4) de la fréquence de résonance (fR) du résonateur (1),
   dans lequel au moins l'une des couches (41, 42) avec l'impédance acoustique faible (Z2) ou l'impédance acoustique supérieure (Z1) présente une épaisseur (d2) comprise entre un quart ($\lambda$/4) et la moitié ($\lambda$/2) de la longueur d'onde dans le résonateur (1).

6. Dispositif selon la revendication précédente, **caractérisé en ce qu'**à partir du résonateur (1) la couche (42) avec l'épaisseur supérieure (d2) constitue la deuxième, quatrième ou sixième couche (42).

7. Dispositif selon l'une des revendications précédentes, **caractérisé en ce que** le résonateur (1) peut être excité par de l'énergie électrique, contient un élément piézoélectrique en tant qu'élément actif et est de préférence conçu sous la forme d'un Film Bulk Acoustic Wave Resonator (FBAR), dans lequel le résonateur (1) est pourvu de connexions électriques (2) pour l'alimentation en énergie électrique.

8. Dispositif selon l'une des revendications précédentes, **caractérisé en ce qu'**une unité d'évaluation (11) est présente pour la commande électrique du résonateur (1) et pour la mesure de la fréquence actuelle respective (f), en particulier des fréquences de résonance (fR1, fR2 ; fR3, fR4).

9. Dispositif selon l'une des revendications précédentes, **caractérisé en ce que** la différence des deux fréquences de résonance (fR1, fR2 ; fR3, fR4) du dispositif (20) est comprise entre un septième et un vingtième de la moyenne arithmétique des deux fréquences de résonance (fR1, fR2 ; fR3, fR4).

10. Dispositif selon l'une des revendications précédentes, **caractérisé en ce que** la sensibilité en masse (km1) à la première fréquence de résonance (fR1 ; fR3) s'écarte de la sensibilité en masse (km2) de la deuxième fréquence de résonance (fR2 ; fR4), et/ou la sensibilité en température (kT1) à la première fréquence de résonance (fR1 ; fR3) s'écarte de la sensibilité en température (kT2) de la deuxième fréquence de résonance (fR2 ; fR4), de sorte que la

connexion de masse (∆m) et la variation de température (∆T) soient déterminables grâce à la mesure des fréquences de résonance actuelles (fR1, fR2 ; fR3, fR4) resp. de leurs décalages (∆fR1, ∆fR2) par rapport à des fréquences de résonance de référence prédéfinies (fR1_ref, fR2_ref) à une température de référence prédéfinie (T_ref) et une masse de référence prédéfinie (m_ref), dans lequel les mesures des fréquences de résonance (fR1, fR2 ; fR3, fR4) sont effectuées l'une après l'autre dans un décalage temporel respectivement négligeable, quasiment sans variation de température et/ou variation de masse intervenant dans cette période de temps.

**11.** Dispositif selon la revendication 9, **caractérisé en ce que** la connexion de masse actuelle (∆m) de la substance à déceler (81) au niveau de la couche (8) et/ou la variation de température actuelle (∆T) sont déterminables à l'aide des formules suivantes :

$$\Delta m = \frac{\Delta fR1 * kT2 - \Delta fR2 * kT1}{km2 * kT1 - km1 * kT2} \qquad \text{(Équation 1)}$$

$$\Delta T = \frac{\Delta fR1 * km2 - \Delta fR2 * km1}{km2 * kT1 - km1 * kT2} \qquad \text{(Équation 2)}$$

avec

AfR1 : modification de la première fréquence de résonance (fR1) du dispositif (20) par rapport à une valeur préalable ou valeur de référence,
∆fR2 : modification de la deuxième fréquence de résonance (fR2) du dispositif (20) par rapport à une valeur préalable () ou valeur de référence,
km1 : sensibilité en masse à la première fréquence de résonance (fR1 ; fR3) du dispositif (20)
km2 : sensibilité en masse à la deuxième fréquence de résonance (fR2 ; fR4) du dispositif (20)
kT1 : la sensibilité en température à la première fréquence de résonance (fR1 ; fR3) du dispositif (20)
kT2 : la sensibilité en température à la deuxième fréquence de résonance (fR2 ; fR4) du dispositif (20).

**12.** Dispositif selon la revendication 10 ou la revendication 11, **caractérisé en ce que** la sensibilité en masse km est définie comme suit :

$$km = \Delta f/\Delta m = cm*fR/m \cong fR^2 \qquad \text{(Équation 3)}$$

dans lequel km est la sensibilité en masse du dispositif (20), fR est la fréquence de résonance du dispositif (20) sans substance absorbée, cm est une constante spécifique au matériau et m est la masse du résonateur (1) par unité de surface, dans lequel la sensibilité en masse km est proportionnelle au carré de la fréquence de résonance fR du dispositif (20) ;
la sensibilité en température kT est définie comme suit :

$$kT = \Delta f/\Delta T = cT*fR/T \qquad \text{(Équation 4)}$$

dans lequel kT est la sensibilité en température du dispositif (20), fR est la fréquence de résonance du dispositif (20) à une température de référence prédéfinie (T_ref), cT est une constante spécifique au matériau et T est la température du résonateur (1) resp. du dispositif (20).

**13.** Procédé pour la détection d'au moins une substance à l'aide d'un dispositif selon l'une des revendications de dispositif précédentes, **caractérisé en ce que** le résonateur (1) est commandé pour l'enregistrement de deux fréquences de résonance actuelles (fR1, fR2 ; fR3, fR4) ou plus dans la plage de celles-ci avec un spectre multifréquence.

**14.** Procédé selon la revendication de procédé 13, **caractérisé en ce que** pour la mesure de la connexion de masse/masse de la substance, les deux fréquences de résonance évidentes (fR1, fR2 ; fR2, fR4) sont mesurées en temps utile, et la connexion de masse et la température sont calculées à partir des deux fréquences de résonance mesurées, dans lequel en particulier la concentration d'une substance issue d'un fluide est mesurable à partir de la connexion de masse.

**15.** Procédé selon l'une des revendications de procédé précédentes, **caractérisé en ce que** la température du résonateur/du capteur/du dispositif est modifiée, les deux fréquences de résonance (fR1, fR2 ; fR3, fR4) du dispositif (20) sont mesurées en continu, grâce à quoi la température actuelle T resp. la variation de température ∆T et la connexion de masse actuelle (∆m) sont déterminées, grâce à quoi une pluralité de processus biologiques et chimiques sont déterminables, par exemple la détermination de la température de fusion d'ADN ou l'étude de la résistance à la chaleur de substances, en particulier de protéines (Heat Shock Proteins).

**16.** Procédé selon l'une des revendications de procédé précédentes, **caractérisé en ce que** la connexion de masse (∆m) est déterminée en faisant abstraction des fluctuations (∆T) de la température, même lorsque la température ambiante fluctue ou le capteur/le dispositif (20) se réchauffe lui-même.

**17.** Procédé selon l'une des revendications de procédé précédentes, **caractérisé en ce que** pour la connexion de masse (∆m), au lieu ou en plus de la détermination de la variation de température (∆T), une variation de paramètre supplémentaire, par exemple une déformation mécanique ou des vibrations, est déterminée par calcul.

FIG 1

# FIG 2

FIG 3

## FIG 4A

Resonanzanalyse

# FIG 4B

Resonanzanalyse

# FIG 4C

Resonanzanalyse

# FIG 4D

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10308975 B4
- DE 102004035812 A1
- DE 102005061344 A1